# DEMANDE DE BREVET EUROPEEN

(11) **EP 1 928 024 A1**
(43) Date de publication de la demande: **04.06.2008**
(21) Numéro de dépôt: 06291859.4
(22) Date de dépôt: 01.12.2006
(51) Int. Cl.: H01L 23/498, H01L 23/58

(54) **Film-support pour modules à puce électronique, lequel est adapté au contrôle automatique de câblage et procédé de fabrication de modules à puce électronique**

(71) Demandeur: Axalto S.A., 92190 Meudon (FR)
(72) Inventeur: Welsch, Pierre-Alois, 92190 Meudon (FR); Chambonneau, Charles, 92190 Meudon (FR); Groeninck, Denis, 92190 Meudon (FR)
(74) Mandataire: Fragnaud, Aude

(57) **Abrégé**

La présente invention concerne un film-support de modules pour dispositif électronique, ledit film-support comportant un film isolant et une pluralité de motifs (5) disposés sur le film isolant, chaque motif définissant des plages de contact métalliques (a-j) correspondant à un module.
Le film-support se distingue en ce que les plages de contact do chaque motif destinées à être connectées à un composant sont décourt-circuitées à l'exception d'une plage de contact (g) qui est reliée à au moins une plage de contact équivalente (g') d'un autre motif par une piste conductrice.
L'invention concerne également un procédé de fabrication de modules mettant en oeuvre ce film-support et le module obtenu.

## Description

La présente invention concerne un film-support pour module électronique. Elle concerne également un procédé de fabrication de modules mettant en oeuvre le flm-support. L'invention est applicable à tout substrat et procédé dans lequel on connecte une puce sur un substrat.

De tels film-supports sont utilisés notamment dans la fabrication de module à puce électronique entrant dans la composition de canes à puce et/ou circuits imprimés. L'invention vise des film-supports de type double-faces comportant notamment un film diélectrique isolant fin en matériau plastique polymère ou ayant un diélectrique en verre / époxy. L'épaisseur de ces films est environ de 75 µm, Toutefois, tout substrat isolant portant des métallisations à connecter est concerné par l'invention et donc équivalent à un film-support.

Une bande ou film-support de module comprend une pluralité de modules, Un procédé de croissance électrolytique, utilisé dans l'obtention des film-support, impose d'avoir les plages de contact métallique toutes reliées entre elles, donc en court-circuit. Par contre, pour que le module soit fonctionnel, ces plages doivent toutes être rendues indépendantes. Généralement, cette opération de décourt-circuitage est réalisée chez un fournisseur de film-support. Elle consiste à perforer ou découper des zones où toutes les plages sont reliées entre elles par un même endroit.

Lors d'une opération de câblage d'un composant électronique, tel une puce de circuit intégré, sur un substrat comportant des métallisations destinées à connecter le composant électronique, on utilise une machine automatique de connexion et de contrôle simultané de la connexion. La connexion est réalisée notamment par une technique de soudure de fils conducteurs aériens (wire bonding).

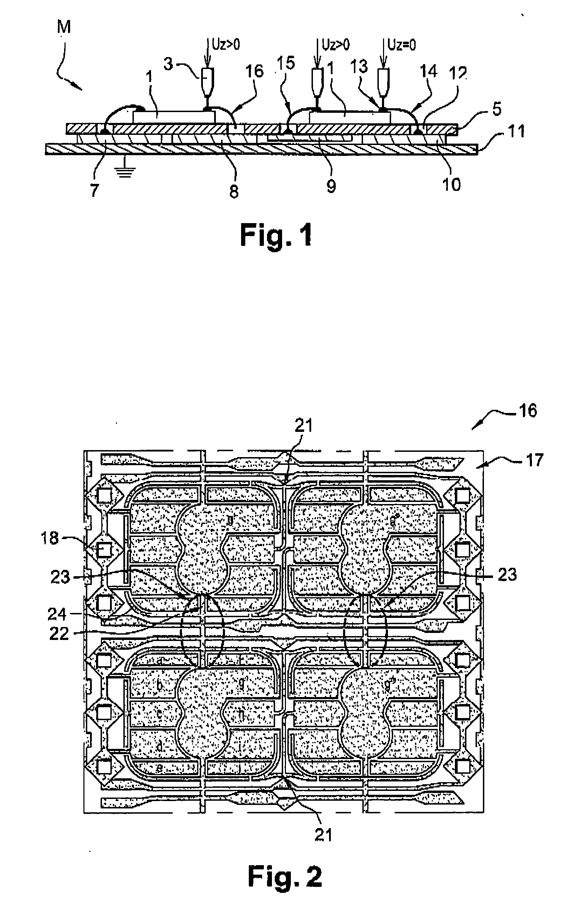

La qualité de la soudure du fil et/ou qualité de la connexion filaire est contrôlée en permanence au cours de la connexion. On procède alors à un test électrique en mesurant l'impédance / tension existant entre le fil et la masse de l'équipement (système NSD), la surface métallique recevant la soudure étant mise à un potentiel déterminé pendant le test. Pour cela, la machine a besoin d'un potentiel de référence, relié à la masse de la machine. Toutefois, après décourt-circuitage, tous les contacts sont indépendants et le potentiel de référence est difficile à trouver : cela suppose qu'au moins une des zones des contacts soit connectée à la masse machine, ce qui n'est pas toujours le cas comme expliqué infra dans la description des figures en référence à la figure 1. Le potentiel de référence est difficile à trouver car la résistance de contact varie en fonction de la géométrie de chaque contact. Il est effectivement difficile d'assurer le maintien d'une multitude de petites parties métalliques comme dans le cas de système hyperstatique.

Il en résulte des erreurs d'appréciation de la qualité des connexions des modules qui peuvent être mis au rebut à tort.

L'invention a pour objectif de résoudre les inconvénients précités. Elle a pour objectif de proposer un film-support de modules qui soit particulièrement adapté à un contrôle qualité des soudures filaires effectuées pour relier la puce aux plages ou plots électriques du support.

La solution consiste dans son principe à effectuer un décourt-circuitage partiel, et plus particulièrement à ne pas décourt-circuiter un des contacts (celui de la masse du module) grâce à une configuration particulière du module et des pistes reliant les plages de contact électrique entre modules sur le film-support.

Cela ne perturbe en rien le processus d'assemblage et n'empêche absolument pas le fonctionnement du module, mais résout le problème de contact avec le bâti : en effet, Il y aura toujours sur la longueur du bâti (plusieurs dizaine de centimètres), au moins un point d'un des modules en contact avec le bâti, ce qui permettra au système de détecter un problème de câblage éventuel.

Si la masse du film est en contact avec le bâti et si le premier fil câblé est à la masse, on obtient alors une configuration électrique stable pour toutes les puces et la détection des bonnes / mauvaises soudure peut alors s'effectuer normalement par rapport à la mesure de référence préalablement apprise par la machine et sur laquelle elle se base pour déterminer les mauvaises connexions.

A cet effet, l'invention a d'abord pour objet un film-support de modules pour dispositif électronique, ledit film-support comportant un film isolant et une pluralité de motifs disposés sur le film isolant, chaque motif définissant des plages de contact métalliques correspondant à un module;

Il se distingue en ce que les plages de contact de chaque module destinées à être connectées à un composant sont décourt-circuitées à l'exception d'une plage de contact qui est reliée à au moins une plage de contact équivalente d'un autre module par une piste conductrice.

Selon une caractéristique préférée, ladite plage de contact constitue une masse électrique (g) du module.

L'invention a également pour objet un procédé de fabrication d'un module électronique, ledit procédé comportant des étapes suivantes :
- fourniture ou réalisation film-support de modules pour dispositif électronique, ledit film-support comportant un film isolant et une pluralité de motifs disposés sur le film isolant, chaque motif définissant des plages de contact métalliques correspondant à un module,
- report d'un composant électronique sur le film-support et connexion filaire du composant aux plages de contact avec une machine présentant un bâti à la masse et une bobine de fil conducteur, ladite machine réalisant la connexion filaire et un contrôle qualité de connexion par mesure de potentiel entre le fil ou bobine de fil et la masse du bâti;

Le procédé se distingue en ce que le film-support de modules est déjà fourni avec les caractéristiques mentionnées précédemment ou en ce que le procédé comprend une étape préalable à la connexion du composant selon laquelle les plages de contact de chaque module, destinées à être connectées à un composant, sont décourt-circuitées à l'exception d'une plage de contact (g) qui est reliée à au moins une plage de contact équivalente d'un autre module par une piste conductrice.

De cette manière, on a l'assurance que la zone connectée peut être efficacement reliée à la masse de la machine et on peut effectuer un contrôle correct des câblages et éviter de mettre au rebut de bons modules.

D'autres caractéristiques et avantages de l'invention apparaîtront à la lecture de la description détaillée qui suit et qui est fournie en référence aux dessins annexés, dans lesquels:
- la fig. 1 illustre une vue en coupe d'une opération de connexion et test simultané de câblage de l'art antérieur mise en oeuvre par l'invention;
- la fig. 2 illustre l'objet de la figure 1 en vue de dessous;
- la figure 3 illustre le procédé de l'invention selon un exemple de mise en oeuvre.

A la figure 1, des puces de circuit intégré 1 sont disposées sur un support isolant 5 et en cours de connexion et de test de câblage à l'aide d'une tête 3 de machine (M) adaptée à cet effet selon un système de détection de défaut de câblage (NSD), acronyme de l'expression anglo-saxonne "non stick detection", système qui mesure le potentiel entre une masse de bâti de machine et une bobine de fil (ou le fil) et de ce fait mesure l'impédance du montage électrique comprenant le circuit intégré, le fil et le film-support.

Des plages de contact 7, 8, 9, 10 toutes indépendantes sont disposées de l'autre côté du film et reposent sur un plateau métallique 11 d'une machine ou poste de production de modules; les plages de contact sont donc en contact ohmique avec le plateau métallique 11 qui est mis à la masse.

En opération, la tête 3 effectue, par exemple, d'abord une soudure du fil métallique qui traverse la tête sur une plage de contact 10 à travers de perforation 12 du film support puis relie un plot 13 de la puce et effectue un test de potentiel du fil 14 avant qu'il ne soit sectionné. Le câblage 10 étant correct, le potentiel mesuré Uz est égal à zéro. Toutefois, on peut adopter un ordre de câblage inverse, la machine de câblage commençant par câbler le plot sur la puce puis finissant par souder le fil sur le film support

Par contre, le câblage 15 est correctement réalisé mais la machine de test détectera un potentiel positif et donc diagnostiquera un problème de connexion qui conduira à écarter ce module comme défectueux. Cette défaillance provient dans le cas présent d'une absence de contact de la plage connectée 9 avec le plateau de la machine qui est à la masse. L'absence de contact peut être provoquée autrement par exemple d'un défaut de planéité du film-support de module, ou un débris isolant sur le plateau.

Concernant l'autre contact 16 réellement défectueux car non réalisé sur la plage de contact, la machine détectera un potentiel Uz positif et donc la même défaillance. A ce jour, et c'est le problème de l'invention, comme il n'est pas possible de faire la différence entre des connexions 15 et 16, on est amené à mettre au rebut des modules en bon état.

A la figure 2, on voit une portion de film-support 16 de modules électroniques selon un mode de réalisation de l'invention. Le film-support se présente généralement sous forme de bobine de film ou diélectrique longiligne comportant des métallisations sur une face et/ou les deux faces. Le film support est également couramment désigné par bande pour module ou substrat pour module et constitue comme précédemment un complexe isolant/conducteur comprenant des surfaces et/ou pistes électriquement conductrices sur un isolant.

Les métallisations définissent plusieurs motifs de plages de contact identiques disposés en chapelet sur le film isolant 17 et chaque motif correspond à un module. Dans l'exemple, la figure montre quatre modules d'un même motif qui comprend neuf surfaces métalliques (a, b, c, d, e, f, g, h, i, j) reliées à différentes pistes conductrices. Ces métallisations sont obtenues par exemple par gravure électrochimique ou par contre-collage d'une bande métallique prédécoupée sur un film diélectrique.

Le film peut comporter des perforations latérales 18 permettant d'entraîner le film-support sur des machines de production. Le film-support peut être bordé latéralement d'au moins rive de bande métallisée disposée autour des perforations et s'étendant en continu sur les bords longitudinaux du film-support.

Conformément à un mode de réalisation de l'invention, les plages de contact de chaque module sont décourt-circuitées par poinçonnage de certains endroits 21 à l'exception d'une plage de contact (g) de chaque module qui est reliée à au moins une plage de contact équivalente (g') d'un autre module par une piste conductrice 22 située dans une zone d'interconnexion 23.

De manière préférée et dans l'exemple, la plage de contact non décourt-circuitée (g) constitue une masse électrique du module. Le cas échéant, d'autres plages de contact non fonctionnelles ou inutiles à la connexion de la puce électronique (a, f, e, j) peuvent rester en court-circuit avec la masse pendant la connexion au composant électronique. Par exemple dans le module, les quatre plages de contact en bordure extérieure du module sont mises au même potentiel que le contact de masse. Le cas échéant les motifs ne sont pas identiques mais les plages reliées ensembles sont soit équivalentes, soit de même nature fonctionnelle.

Dans l'exemple tous les modules sont interconnectés par leur plage de masse (g) mais, il suffit que deux motifs au moins soient interconnectés. Ils peuvent être adjacents où éloignés, mais il est préféré qu'ils soient tous deux présents contre le plateau de machine pendant le test de câblage ou l'un des deux. Toutefois, lorsque le câblage s'effectue simultanément sur quatre à huit modules, il suffit en fait que l'un des quatre ou des huit modules soit au contact du plateau, ce qui augmente les chances d'avoir au moins une partie en contact avec le bâti.

De manière avantageuse, en choisissant la plage de contact correspondant à la masse comme plage d'interconnexion (g) entre les modules, il est possible, après connexion, de tester directement le composant malgré le fait que les modules soient reliés au moins deux à deux. Pour plus de sureté, ladite plage de contact peut être reliée également par une seconde piste métallique à au moins une rive bande du film-support. Les roues d'entrainement et/ou pinces du film-support constituent également une masse susceptible d'être prise en considération par la machine de câblage et de test associé.

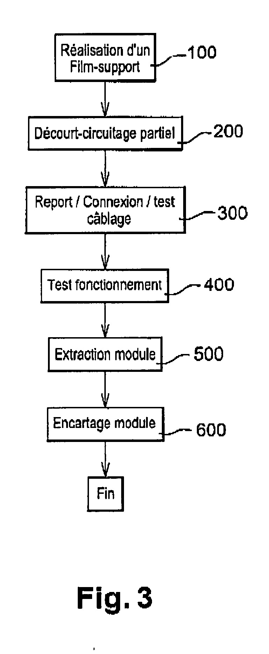

La figure 3, illustre un procédé de fabrication d'un module électronique selon un mode de mise en oeuvre de l'invention:
- Au cours d'une première étape 100, on réalise un film-support conforme à l'exemple ci-dessus mais comportant toutes les plages de contact en court-circuit. Cette mise en court-circuit est notamment utile pour réaliser ou compléter des métallisations électrochimiques ou une gravure;
- A l'étape 200, dite de décourt-circuitage, les plages de contact (a, b, c, d, e, f, h, i, j) sont rendues indépendantes électriquement; Cette opération est réalisée par exemple chez un fournisseur de film-support; Les plages de contact sont déconnectées entre-elles, déconnectées des rives de bandes latérales, si elles existent, à l'exception des plages de contact (g, g') représentant la masse des modules qui demeurent connectées toutes entre elles; Facultativement, elles peuvent également demeurer connectées aux rives de bande; Cette opération peut s'effectuer par découpe ou poinçonnage localisé d'une zone de quelques millimètres carrés notamment à des endroits 21 rassemblant des pistes de connexion aux plages de contact électrique; Ce décourt-circuitage partiel doit être réalisé avant la connexion de la puce conformément aux enseignements de l'invention;
- A l'étape 300, on effectue un report d'au moins un composant électronique 1, sur le film-support à l'emplacement de chaque motif de plages de contact; Le report peut s'effectuer sur l'isolant ou sur une surface métallique;
- on effectue ensuite dans la toulée une connexion des composants aux plages de contact, par soudure filaire (dite wire-bonding, ou "edge bonding") avec une machine (M) de connexion filaire et de test de câblage comme décrite précédemment ; Un enrobage éventuel avec matière de protection mécanique peut être effectué ensuite.
- A l'étape 400, on peut effectuer un test de fonctionnement et/ou personnalisation du circuit intégré lui-même distinct de l'opération de test de câblage;
- A l'étape 500, on peut effectuer immédiatement une extraction des modules du film support par découpe / poinçonnage autour de ses plages de contact électrique; l'extraction a pour effet d'enlever le court-circuit résiduel existant entre les plages de contact de masse et de supprimer des connexions résiduelles à des pistes; Le cas échéant, cette étape peut être reportée, les bobines étant stockées ainsi avec une feuille intercalaire.
- A l'étape 600 finale, on procède à un encartage dans un corps de carte à puce.

Le module obtenu peut constituer un dispositif électronique lui-même ou être intégré par exemple dans un support notamment par encartage à l'étape 700 ou dans un autre dispositif quelconque au cours d'étapes ultérieures pour former un dispositif électronique comprenant ce module.

## Revendications

**1.** Film-support de modules pour dispositif électronique, ledit film-support comportant un film isolant et une pluralité de motifs (5) disposés sur le film isolant, chaque motif définissant des plages de contact métalliques (a - j) correspondant à un module,
**caractérisé en ce que** les plages de contact de chaque module destinées à être connectées à un composant sont décourt-circuitées à l'exception d'une plage de contact (g) qui est reliée à au moins une plage de contact équivalente (g') d'un autre module par une piste conductrice.

**2.** Film-support de modules selon la revendication précédente, **caractérisé en ce que** ladite plage de contact constitue une masse électrique (g) du module.

**3.** Film-support de modules selon l'une des revendications précédentes, **caractérisé en ce que** ladite plage de contact est également reliée par une seconde piste métallique (24) jusqu'à au moins une rive bande.

**4.** Procédé de fabrication d'un module électronique, ledit procédé comportant des étapes suivantes :
- fourniture ou réalisation film-support de modules pour dispositif électronique, ledit film-support comportant un film isolant et une pluralité de motifs disposés sur le film isolant, chaque motif définissant des plages de contact métalliques (a-j) correspondant à un module,
- report d'un composant électronique sur le film-support et connexion filaire du composant aux plages de contact avec une machine présentant un bâti à la masse et une bobine de fil conducteur, ladite machine réalisant la connexion filaire et un contrôle qualité de connexion par mesure de potentiel entre le fil ou bobine de fil et la masse du bâti;
**caractérisé en ce que** le film-support de modules est conforme à l'une des revendications 1 à 3,
- ou **en ce que** le procédé comprend une étape préalable à la connexion du composant selon laquelle les plages de contact de chaque module, destinées à être connectées à un composant, sont décourt-circuitées à l'exception d'une plage de contact (g) qui est reliée à au moins une plage de contact équivalente (g') d'un autre module par une piste Conductrice (22).

**6.** Dispositif électronique comportant le module obtenu par la mise en oeuvre du procédé conforme à la revendication précédente.
